# DEMANDE DE BREVET EUROPEEN

(11) **EP 4 114 158 A1**
(43) Date de publication de la demande: **04.01.2023**
(21) Numéro de dépôt: 22182064.0
(22) Date de dépôt: 29.06.2022
(51) Int. Cl.: H05K 7/14

(54) **MODULE ELECTRONIQUE AVEC SURMOULAGE, DISPOSITIFS COMPORTANT UN TEL MODULE ELECTRONIQUE ET PROCEDE DE FABRICATION D'UN TEL MODULE ELECTRONIQUE**

(30) Priorité: 30.06.2021 FR 2107031
(71) Demandeur: VALEO EQUIPEMENTS ELECTRIQUES MOTEUR, 94046 Créteil Cedex (FR)
(72) Inventeur: VERCAMBRE, Virginie, 94000 CRETEIL (FR); KRIKEB, Mohammed, 94046 CRETEIL CEDEX (FR); HOUARD, Jean Luc, 95892 CERGY PONTOISE (FR)
(74) Mandataire: Valeo Powertrain Systems

(57) **Abrégé**

L'invention concerne un module électronique comprenant un premier composant électronique, une première pièce de connexion électrique présentant une première plaque principale (3061) et comprenant sur une face supérieure (3081) de ladite première plaque principale (3061) une zone de montage (3091-1) destinée à recevoir le premier composant électronique, le premier composant électronique étant fixé par brasage sur la zone de montage (3091-1) de la face supérieure (3081) de la première pièce de connexion électrique et un surmoulage isolant électrique, par recouvrant au moins une partie de la face supérieure (3081) de la plaque principale (3061) de la première pièces de connexion électrique, le module électronique étant caractérisé en ce que ladite face supérieure (308₁) de la première plaque principale (306₁) de ladite première pièce de connexion électrique comprend en outre un canal (307₁₋₁) entourant ladite zone de montage (309₁₋₁).

## Description

La présente invention concerne un module électronique avec surmoulage, un système électronique, un convertisseur de tension et un engin de mobilité comportant un tel module électronique, ainsi qu'un procédé de fabrication d'un tel module électronique.

Il est connu un module électronique comportant :
- un premier composant électronique ;
- une première pièce de connexion électrique, de préférence en métal, présentant une première plaque principale et comprenant sur une face supérieure de ladite première plaque principale une zone de montage destinée à recevoir le premier composant électronique, le premier composant électronique fixé par brasage sur la zone de montage de la première pièce de connexion électrique ;
- un surmoulage isolant électrique, par exemple en résine, recouvrant au moins une partie de la face supérieure de la première plaque principale de la première pièces de connexion électrique;

Dans un module électronique selon l'art antérieur, la présence d'une zone de montage permet de positionner le premier composant électronique sur la face supérieure de la première plaque principale de la première pièce de connexion électrique.

Mais un tel module électronique présente l'inconvénient que, lors de la fixation du premier composant électronique sur la zone de montage, la brasure peut s'écouler en dehors de la zone de montage de la première plaque principale et venir ainsi salir cette première plaque principale.

Pour s'affranchir du problème précité, il est proposé, selon un premier aspect de l'invention, un module électronique comportant :
- un premier composant électronique ;
- une première pièce de connexion électrique, de préférence en métal, présentant une première plaque principale et comprenant sur une face supérieure de ladite première plaque principale une zone de montage destinée à recevoir ledit premier composant électronique, ledit premier composant électronique étant fixé par brasage sur la zone de montage de la première pièce de connexion électrique ;
- un surmoulage isolant électrique, par exemple en résine, recouvrant au moins une partie de la face supérieure de la première plaque principale de la première pièce de connexion électrique;
caractérisé en ce que la face supérieure de la première plaque principale de la première pièces de connexion électrique comprend en outre un canal entourant la zone de montage.

Grâce à l'invention, un éventuel excès de brasure s'écoule dans le canal entourant la zone de montage empêchant ainsi cet excès éventuel de s'écouler en dehors de la zone de montage de la première plaque principale.

Un module électronique selon l'invention peut en outre comporter une ou plusieurs des caractéristiques optionnelles suivantes, prises isolément ou bien selon n'importe quelle combinaison techniquement possible.

Selon une première caractéristique, le module électronique est un module de puissance.

Au sens de l'invention, un module de puissance est un module électronique contenant des puces semi-conductrices (par exemple des transistors dit de puissance), conçu pour réaliser des circuits de conversion d'énergie, comme ceux par exemple d'une cellule de commutation, d'un onduleur ou encore d'un pont redresseur.

Selon une autre caractéristique, la brasure est formée d'un alliage sans plomb, par exemple d'un alliage à base d'étain, d'argent et de cuivre, d'un alliage à base d'étain, d'argent, de cuivre et d'antimoine, d'un alliage d'étain de cuivre et de nickel, d'un alliage d'étain, d'argent, de cuivre et de cérium, ou encore d'un alliage d'étain, d'argent, de cuivre, d'antimoine, de nickel et de bismuth.

Par exemple, ces alliages peuvent avoir les compositions (en pourcentage massiques) suivantes : 96.5%Sn-3.0%Ag-0.5%Cu, 95.5%Sn-3.8%Ag-0.7%Cu, 96.2%Sn-2.5%Ag-0.8%Cu-0.5%Sb, 99.3%Sn-0.7%Cu-0.05%Ni, 96.4%Sn-3.0%Ag-0.6%Cu-0.01%Ce, ou 90.85%Sn-3.8%Ag-0.7%Cu-1.5%Sb-0.15%Ni-3.0%Bi.

Selon une autre caractéristique, la première plaque principale de la première pièce de connexion électrique s'étend selon un plan principal.

Selon une autre caractéristique, le module électronique comprend en outre une deuxième pièce de connexion électrique de préférence en métal, présentant une deuxième plaque principale, la première et la deuxième plaque principale s'étendant selon un même plan principal de manière à être sensiblement coplanaires.

Selon une autre caractéristique, le premier composant électronique est connecté électriquement entre la première face supérieure de la première plaque principale et une deuxième face supérieure de la deuxième plaque principale.

Selon une autre caractéristique, le premier composant électronique est un transistor.

Selon une autre caractéristique, le premier composant électronique est un transistor de type FET (de l'anglais « Field-Effect Transistor ») ou de type IGBT (de l'anglais « Insulated-Gate Bipolar Transistor »).

Selon une autre caractéristique, le transistor de type FET est un MOSFET en silicium (Si-MOSFET) ou en carbure de silicium (SiC-MOSFET) ou est un transistor FET en nitrure de gallium (GaN-FET).

Selon une autre caractéristique, le premier composant électronique est un transistor HEMT (de l'anglais « high-electron-mobility transistor ») par exemple en nitrure de gallium.

Selon une autre caractéristique, le premier composant électronique est un transistor ayant la forme d'une plaque, par exemple sensiblement rectangulaire, présentant une face supérieure et une face inférieure.

Selon une autre caractéristique, le premier composant électronique est un transistor présentant une face inférieure plaquée contre la face supérieure de la première plaque principale de la première pièce de connexion électrique à laquelle le premier composant électronique est connecté.

Selon une autre caractéristique, le premier composant électronique est un transistor présentant une face supérieure connectée électriquement, par exemple par au moins un ruban ou un fil, à la deuxième face supérieure de la deuxième plaque principale.

Selon une autre caractéristique, le surmoulage isolant électrique recouvre au moins une partie du premier composant électronique.

Selon une autre caractéristique, le surmoulage isolant électrique recouvre complètement le premier composant électronique.

Selon une autre caractéristique, le surmoulage isolant électrique recouvre au moins une partie d'une face supérieure de la deuxième plaque principale de la deuxième pièce de connexion électrique.

Selon une autre caractéristique, au moins une des pièces de connexion électrique comprend au moins un connecteur électrique se projetant depuis sa plaque principale ;

Selon une autre caractéristique, le canal est discontinu.

Selon une autre caractéristique, le canal a une forme sensiblement rectangulaire.

Selon une autre caractéristique, la zone de montage à une forme sensiblement rectangulaire.

Selon une autre caractéristique, le canal présente une discontinuité au niveau d'au moins un sommet de sa forme sensiblement rectangulaire.

Selon une autre caractéristique, le canal présente une discontinuité au niveau d'un milieu d'au moins un des côtés de sa forme sensiblement rectangulaire.

Selon une autre caractéristique, le canal est réalisé par emboutissage et/ou par estampage. La réalisation du canal par emboutissage et/ou par estampage provoque une déformation locale de la face supérieure de la première plaque principale de sorte que de chaque côté du canal une excroissance de métal s'élève depuis la face supérieure de la première plaque principale. Avantageusement, ces excroissances permettent de s'assurer que le premier composant électronique ne se déplace pas et reste positionné sur sa zone de montage lors de sa brasure sur celle-ci, en particulier pendant la phase de refusion.

Selon une autre caractéristique, le canal est réalisé par gravure laser.

Selon une autre caractéristique, le canal a une section ayant une forme trapézoïdale.

Selon une autre caractéristique, le canal a une section symétrique.

Selon une autre caractéristique, le canal a une section comportant un fond et deux parois latérales opposées l'une à l'autre et dans lequel la paroi latérale située du côté de la zone de montage a une pente plus grande que la paroi latérale opposée.

Selon une autre caractéristique, le fond à une longueur nulle ou non nulle.

La pente d'une paroi latérale est égale à la tangente de la valeur absolue de l'angle aigu formé par l'intersection de cette paroi latérale et de la face supérieure sensiblement plane de la première plaque principale. Dans le cas limite, où la pente devient infinie, la paroi latérale située du côté de la zone de montage est sensiblement perpendiculaire à la face supérieure de ladite première plaque principale

Ainsi, selon une autre caractéristique, la paroi latérale située du côté de la zone de montage est sensiblement perpendiculaire à la face supérieure de ladite première plaque principale.

Ainsi, en modifiant la forme du canal (profondeur, section trapézoïdale symétrique ou non), il est possible de modifier la forme des excroissances de chaque côté du canal et ainsi simultanément de garantir la position du premier composant électronique sur sa zone de montage et de limiter la formation de bulle de gaz (en anglais, on parle de « voids ») sous le premier composant électronique lors de sa brasure sur sa zone de montage.

Selon une autre caractéristique, le surmoulage laisse apparent au moins une partie d'une face inférieure de la première plaque principale de la première pièce de connexion électrique, cette partie laissée apparente étant conçue pour être plaquée contre un dissipateur thermique.

Selon une autre caractéristique, le surmoulage laisse apparent au moins une partie d'une face inférieure de la première plaque principale de la première pièce de connexion électrique cette partie laissée apparente étant conçue pour être plaquée contre un dissipateur thermique.

Selon une autre caractéristique, le surmoulage laisse apparent au moins une partie d'une face inférieure de la deuxième plaque principale de la deuxième pièce de connexion électrique, cette partie laissée apparente étant conçue pour être plaquée contre un dissipateur thermique.

Il est également proposé, selon un deuxième aspect de l'invention, un système électronique comprenant un dissipateur thermique et un module électronique selon le premier aspect de l'invention, et dans lequel le dissipateur de chaleur est en contact thermique avec au moins une partie de la face inférieure laissée apparente par le surmoulage.

Selon une caractéristique optionnelle, le dissipateur thermique est en contact thermique avec au moins une partie de la face inférieure laissées apparentes par le surmoulage via un élément de liaison thermique électriquement isolant.

Il est également proposé, selon un troisième aspect de l'invention, un convertisseur de tension comprenant un module électronique selon le premier aspect de l'invention ou bien un système électronique selon le deuxième aspect de l'invention.

Il est également proposé, un engin de mobilité comprenant un module électronique selon le premier aspect de l'invention ou un système électronique selon le deuxième aspect de l'invention ou un convertisseur de tension selon le troisième aspect de l'invention.

Un engin de mobilité est par exemple un véhicule terrestre à moteur, un aéronef ou un drone.

Un véhicule terrestre à moteur est par exemple un véhicule automobile, une moto, un vélo motorisé ou un fauteuil roulant motorisé.

Il est également proposé un procédé de fabrication d'un module électronique selon le premier aspect de l'invention comprenant :
- L'obtention d'un premier composant électronique ;
- L'obtention d'une première pièce de connexion électrique, de préférence en métal, présentant une première plaque principale comprenant une zone de montage destinée à recevoir le premier composant électronique,
- La réalisation d'un canal entourant la zone de montage sur la face supérieure de la première plaque principale de la première pièce de connexion électrique.
- La fixation par brasage du premier composant électronique sur la zone de montage de la première pièce de connexion électrique ;
- La réalisation d'un surmoulage isolant électrique, par exemple en résine, recouvrant au moins une partie de la face supérieure de la première plaque principale de la première pièce de connexion électrique.

Un procédé selon l'invention peut en outre comporter une ou plusieurs des caractéristiques optionnelles suivantes, prises isolément ou bien selon n'importe quelle combinaison techniquement possible.

Selon une première caractéristique, le procédé comprend en outre l'obtention d'une plaque conductrice, de préférence en métal, s'étendant selon un plan principal.

Selon une autre caractéristique, le procédé comprend en outre la découpe, dans la plaque conductrice, d'une part, d'une pièce de cadre et de plusieurs pièces planes comportant au moins une première et une deuxième pièces de connexion électrique présentant chacune une plaque principale, les plaques principales s'étendant selon le plan principal de manière à être sensiblement coplanaires, au moins une des pièces de connexion électrique comprenant au moins un connecteur électrique se projetant depuis sa plaque principale, et, d'autre part, de pattes d'attache de chaque plaque principale avec au moins une de la ou des autres pièces.

Selon une autre caractéristique, le procédé comprend en outre la connexion électrique du premier composant électronique entre la première et la deuxième face supérieure.

L'invention sera mieux comprise à l'aide de la description qui va suivre, donnée uniquement à titre d'exemple et faite en se référant aux dessins annexés dans lesquels :
[Fig. 1] la figure 1 représente schématiquement un système électronique comportant un convertisseur de tension mettant en œuvre l'invention,
[Fig. 2] la figure 2 est une vue éclatée en trois dimensions du convertisseur de tension de la figure 1,
[Fig.3] la figure 3 est une vue en trois dimensions de dessus d'un module de puissance du convertisseur de tension de la figure 2, sans surmoulage,
[Fig.4] la figure 4 est une vue de dessus d'une première pièce de connexion électrique du module de puissance de la figure 3,
[Fig.5] la figure 5 est une coupe de la première pièce de connexion électrique selon l'axe AA représenté à la figure 4,
[Fig.6] la figure 6 est une coupe de la première pièce de connexion électrique selon l'axe AA représenté à la figure 4 dans une variante de réalisation du module de puissance de la figure 3,
[Fig.7] la figure 7 est une vue en trois dimensions de dessous du module de puissance de la figures 3, sans surmoulage,
[Fig.8] la figure 8 est une vue similaire à celle de la figure 3, avec surmoulage,
[Fig.9] la figure 9 est une vue similaire à celle de la figure 7, avec surmoulage,
[Fig.10] la figure 10 est une vue en trois dimensions de dessous d'une plaque découpée pour former des pièces de connexion électrique du module de puissance, avec surmoulage, et
[Fig.11] la figure 11 illustre les étapes successives d'un procédé de fabrication d'un module de puissance, selon un mode de réalisation de l'invention.
En référence à la figure 1, un système électronique 100 mettant en œuvre l'invention dans un mode de réalisation de l'invention va à présent être décrit.

Le système électronique 100 est par exemple destiné à être implanté dans un véhicule automobile.

Le système électronique 100 comporte tout d'abord une source d'alimentation électrique 102 conçue pour délivrer une tension continue U, par exemple comprise entre 10 V et 100 V, par exemple 48 V ou bien 12 V.

La source d'alimentation électrique 102 est donc une source de tension continue. Cette source d'alimentation électrique comporte par exemple une batterie.

Le système électronique 100 comporte en outre une machine électrique 130 comportant plusieurs phases (non représentées) destinées à présenter des tensions de phase respectives.

Le système électronique 100 comporte en outre un convertisseur de tension 104 connecté entre la source d'alimentation électrique 102 et la machine électrique 130 pour effectuer une conversion entre la tension continue U et les tensions de phase.

Le convertisseur de tension 104 comporte tout d'abord une barre omnibus positive 106 et une barre omnibus négative 108 destinées à être connectées à la source d'alimentation électrique 102 pour recevoir la tension continue U, la barre omnibus positive 106 recevant un potentiel électrique haut et la barre omnibus négative 108 recevant un potentiel électrique bas.

Le convertisseur de tension 104 comporte en outre au moins un module électrique 110. Ce module électrique 110 est un module de puissance. Le module de puissance 110 comporte une ou plusieurs barres omnibus de phase destinées être respectivement connectées à une ou plusieurs phases de la machine électrique 130, pour fournir leurs tensions de phase respectives.

Dans l'exemple décrit, le convertisseur de tension 104 comporte trois modules de puissance 110 comportant chacun deux barres omnibus de phase 122₁, 1222 connectées à deux phases de la machine électrique 130.

Plus précisément, dans l'exemple décrit, la machine électrique 130 comporte deux systèmes triphasés comportant chacun trois phases, et destinés à être électriquement déphasés de 120° l'un par rapport à l'autre. De préférence, les premières barres omnibus de phase 122₁ des modules de puissance 110 sont respectivement connectées aux trois phases du premier système triphasé, tandis que les deuxièmes barres omnibus de phase 1222 des modules de puissance 110 sont respectivement connectées aux trois phases du deuxième système triphasé.

Chaque module de puissance 110 comporte, pour chaque barre omnibus de phase 122₁, un premier composant électronique, (ici un interrupteur de côté haut 112ᵢ) connecté entre la barre omnibus positive 106 et la barre omnibus de phase 122₁ et un deuxième composant électronique (ici un interrupteur de côté bas 114₁), connecté entre la barre omnibus de phase 122₁ et la barre omnibus négative 108. Ainsi, les interrupteurs 112₁, 114₁ sont agencés de manière à former un bras de commutation, dans lequel la barre omnibus de phase 122₁ forme un point milieu.

Chaque module de puissance 110 comporte également, pour chaque barre omnibus de phase 1222, un troisième composant électronique (ici un interrupteur de côté haut 1122) connecté entre la barre omnibus positive 106 et la barre omnibus de phase 1222 et un quatrième composant électronique (ici un interrupteur de côté bas 1142) connecté entre la barre omnibus de phase 1222 et la barre omnibus négative 108. Ainsi, les interrupteurs 1122, 1142 sont agencés de manière à former un bras de commutation, dans lequel la barre omnibus de phase 1222 forme un point milieu.

Chaque interrupteur 112₁, 114₁, 1122, 1142 comporte des première et deuxième bornes principales 116, 118 et une borne de commande 120 destinée à sélectivement ouvrir et fermer l'interrupteur 112₁, 114₁, 1122, 1142 entre ses deux bornes principales 116, 118 en fonction d'un signal de commande qui lui est appliqué. Les interrupteurs 112₁, 114₁, 1122, 1142 sont de préférence des transistors, par exemple des transistors à effet de champ à structure métal-oxyde-semiconducteur (de l'anglais « Metal Oxide Semiconductor Field Effect Transistor » ou MOSFET) présentant une grille formant la borne de commande 120, et un drain et une source formant respectivement les bornes principales 116, 118. Alternativement, les interrupteurs 112₁, 114₁, 1122, 1142 pourraient être des transistors bipolaires à grille isolée (de l'anglais « Insulated Gate Bipolar Transistor » ou IGBT).

Dans l'exemple décrit, les interrupteurs 112₁, 114₁, 1122, 1142 ont chacun la forme d'une plaque, par exemple sensiblement rectangulaire, présentant une face supérieure et une face inférieure. La première borne principale 116 s'étend sur la face inférieure, tandis que la deuxième borne principale 118 s'étend sur la face supérieure. Les interrupteurs 112₁, 114₁, 1122, 1142 sont destinés à être traversés, entre leurs bornes principales 116, 118, par un courant supérieure à 1 A.

Il sera apprécié que la barre omnibus positive 106, la barre omnibus négative 108 et les barres omnibus de phase 122₁, 1222 sont des conducteurs électriques rigides conçus pour supporter les courants électriques d'au moins 1 A destinés à traverser les interrupteurs 112₁, 114₁, 1122, 1142. Elles présentent de préférence une épaisseur d'au moins 1 mm.

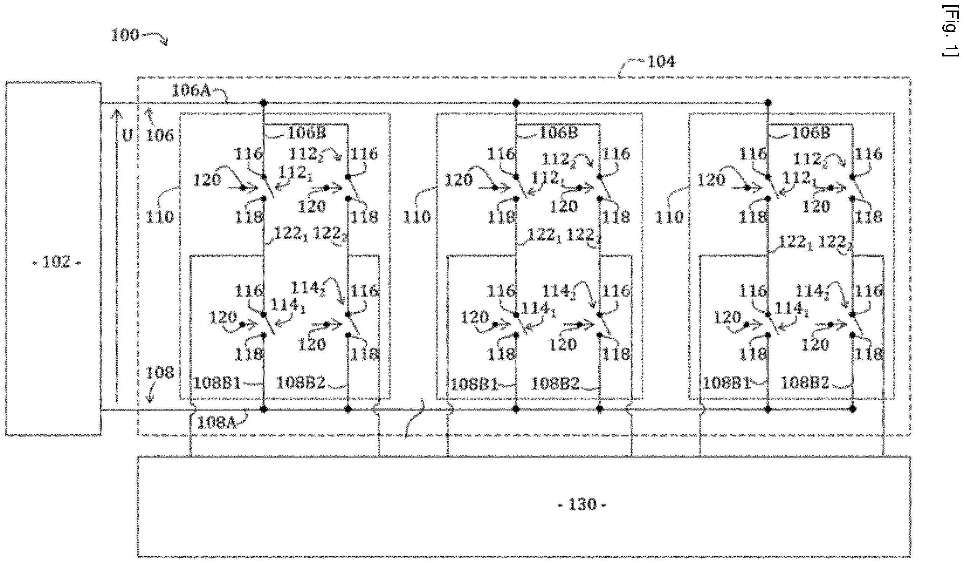

Par ailleurs, dans l'exemple décrit, la barre omnibus positive 106 comporte tout d'abord une barre omnibus commune positive 106A reliant les modules de puissance 110 et, dans chaque module de puissance 110, une barre omnibus locale positive 106B connectée à la barre omnibus commune positive 106A. De manière similaire, la barre omnibus négative 108 comporte une barre omnibus commune négative 108A reliant les modules de puissance 110 et, dans chaque module de puissance 110, une barre omnibus locale négative 108B1, 108B2 pour chaque interrupteur de côté bas 114₁, 1142, les barres omnibus locales négatives 108B1, 108B2 étant connectées à la barre omnibus commune négative 108A. Les connexions sont représentées sur la figure 1 par des losanges.

En outre, dans l'exemple décrit, la barre omnibus commune positive 106A et la barre omnibus commune négative 108A sont chacune formée d'une seule pièce conductrice.

En outre, dans l'exemple décrit, la machine électrique 130 est une machine électrique tournante ayant a à la fois une fonction d'alternateur et de moteur électrique. Plus précisément, le véhicule automobile comporte en outre un moteur thermique (non représenté) présentant un axe de sortie auquel la machine électrique 130 est reliée par exemple par une courroie (non représentée). Le moteur thermique est destiné à entraîner des roues du véhicule automobile par l'intermédiaire de son axe de sortie. Ainsi, en fonctionnement comme alternateur, la machine électrique 130 fournit de l'énergie électrique en direction de la source d'alimentation électrique 102 à partir de la rotation de l'axe de sortie. Le convertisseur de tension 104 fonctionne alors comme redresseur. En fonctionnement comme moteur électrique, la machine électrique entraîne l'arbre de sortie (en complément ou bien à la place du moteur thermique). Le convertisseur de tension 104 fonctionne alors comme onduleur.

La machine électrique 130 est par exemple localisée dans une boîte de vitesses ou bien dans un embrayage du véhicule automobile ou bien en lieu et place de l'alternateur.

Dans la suite de la description, la structure et la disposition des éléments du convertisseur de tension 104 vont être décrits plus en détails, en référence à une direction verticale H-B, « H » représentant le haut et « B » représentant le bas. Cette direction verticale H-B étant notée sur les figures par la référence V.

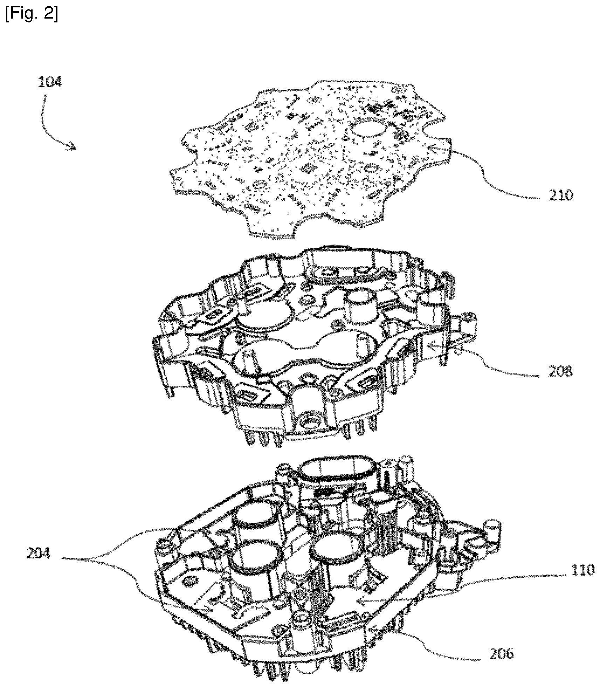

En référence à la figure 2, le convertisseur de tension 104 comprend un dissipateur thermique 206, également appelé dissipateur de chaleur, présentant des surfaces d'échange thermique 204 sur lesquelles sont respectivement montés les modules de puissance 110 (un seul module de puissance 110 est représenté sur la figure 2). L'échange thermique entre la surface d'échange thermique 204 du dissipateur thermique 206 et le module de puissance 110 est réalisé par exemple grâce à un contact, direct ou par l'intermédiaire d'une pate conductrice thermiquement, entre la surface d'échange thermique 204 du dissipateur thermique 206 et le module de puissance 110.

Le convertisseur de tension 104 comprend également un boitier support 208 sur lequel est fixé un module électronique secondaire comme un module de contrôle 210. Dans l'exemple de la figure 1, le module de contrôle 210 est une carte de contrôle. En outre et de façon optionnelle, le boitier support 208 est monté sur le dissipateur thermique 206.

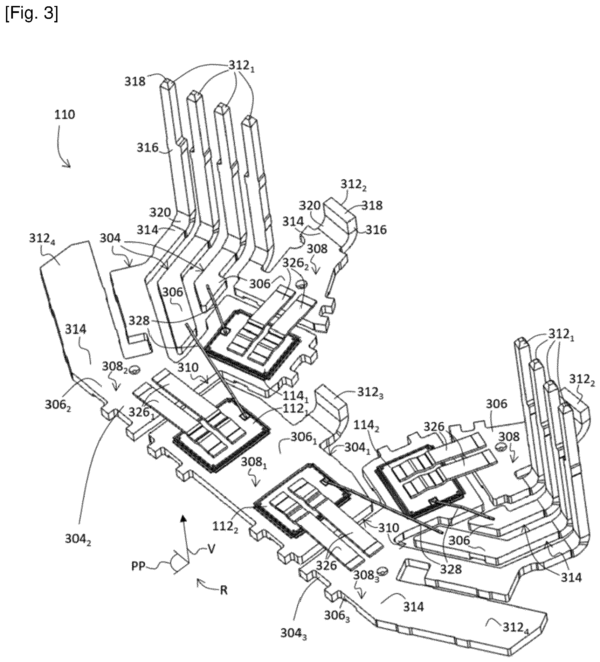

En référence à la figure 3, le module de puissance 110 comporte plusieurs pièces de connexion électrique 304, 304₁, 3042, 304₃ de préférence en métal.

Chaque pièce de connexion électrique 304, 304₁, 3042, 304₃ présente une plaque principale 306, 306₁, 306₂, 306₃ s'étendant selon un plan principal PP horizontal, le même pour toutes les plaques principales 306, 306₁, 306₂, 306₃ de manière à ce que les plaques principales 306, 306₁, 306₂, 306₃ soient sensiblement coplanaires. En particulier, dans l'exemple décrit, les plaques principales 306, 306₁, 306₂, 306₃ présentent des faces supérieures 308, 308₁, 308₂, 308₃ horizontales respectives s'étendant au même niveau. Par soucis de clarté, les faces supérieures 308, 308₁, 308₂, 308₃ ne sont indiquées sur la figure 3 que pour les plaques principales 306, 306₁, 306₂, 306₃ les plus grandes.

En particulier, le module de puissance 110 comporte une première pièce de connexion électrique 304₁ ayant une plaque principale 306₁ présentant une face supérieure 308₁, une deuxième pièce de connexion électrique 3042 ayant une plaque principale 306₂ présentant une face supérieure 308₂ et une troisième pièce de connexion électrique 304₃ ayant une plaque principale 306₃ présentant une face supérieure 308₃.

Par ailleurs, les plaques principales 306, 306₁, 306₂, 306₃ sont séparées les unes des autres selon le plan principal PP par au moins un interstice 310. Dans l'exemple décrit, chaque interstice 310 présente une largeur inférieure ou égale à un cinq millimètres. Cela signifie que les deux plaques principales délimitant l'interstice 310 sont distantes d'au plus cinq millimètres le long de cet interstice 310.

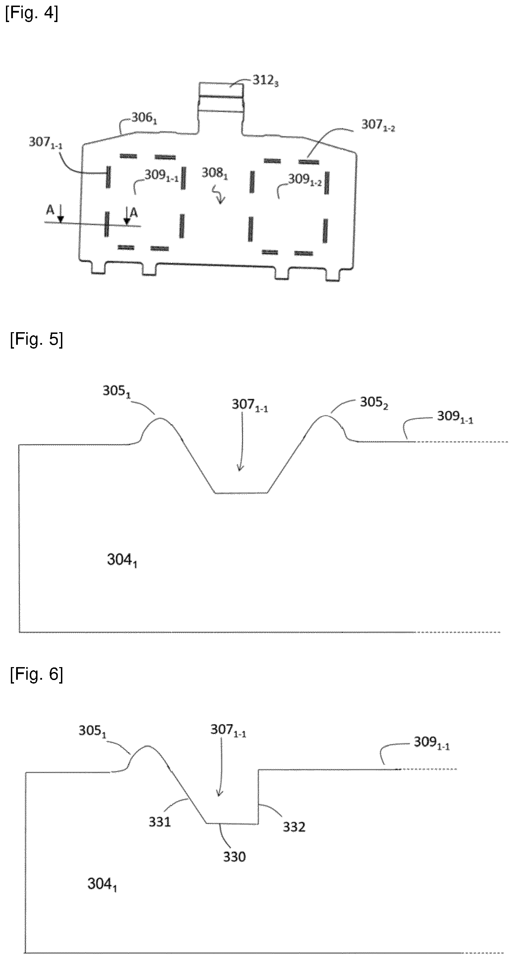

Comme représenté sur la figure 4, la face supérieure 308₁ de la plaque principales 306₁ comprend une zone de montage 309₁₋₁ destinée à recevoir le transistors 112₁ et une zone de montage 309₁₋₂ destinée à recevoir le transistors 1122. Cette face supérieure de la plaque principale 306₁ comprend en outre un canal 307₁₋₁ entourant la zone de montage 309₁₋₁ et un canal 307₁₋₂ entourant la zone de montage 309₁₋₂. Dans l'exemple décrit ici, les canaux 307₁₋₁ et 307₁₋₂ sont discontinus.

De façon similaire, la face supérieure 308₂ de la plaque principales 306₂ comprend une zone de montage 309₂ destinée à recevoir le transistors 114₁, la zone de montage 309₂ étant entouré par un canal 3072 et la face supérieure de la plaque principales 306₃ comprend une zone de montage 309₃ destinée à recevoir le transistors 1142, la zone de montage 309₃ étant entouré par un canal 307₃.

Les zones de montage 309₁₋₁, 309₁₋₂, 309₂ et 309₃ ont dans l'exemple décrit ici une forme sensiblement rectangulaire.

Les canaux 307₁₋₁, 307₁₋₂, 3072 et 307₃ sont par exemple réalisés par emboutissage (de l'anglais « metal stamping »), ou en variante par estampage, de sorte que la section de ces canaux 307₁₋₁, 307₁₋₂, 3072 et 307₃ a une forme trapézoïdale.

Comme représente sur la figure 3, de manière générale, au moins une des pièces de connexion électrique 304 (toutes dans l'exemple décrit) présente en outre au moins un connecteur électrique se projetant depuis sa plaque principale 306, 306₁, 306₂, 306₃. Chaque connecteur électrique est par exemple soit sous la forme d'une broche 312₁, soit sous la forme d'une languette pliée 3122, 312₃, soit encore sous la forme d'une languette droite 3124.

Dans l'exemple décrit ici, les languettes droites 312₄ forment avec leurs plaques principales 306₂, 306₃ les barres omnibus de phase 122₁, 1222, la languette pliée 312₃ forme avec sa plaque principale 306₁ la barre omnibus locale positive 106B et les languettes pliées 3122 forment avec leurs plaques principales 306 les barres omnibus locales négatives 108B1, 108B2.

Chaque connecteur électrique 312₁, 3122, 312₃ présente une extrémité fixe 314 fixée à la plaque principale 306, 306₁, une portion principale 316 s'étendant verticalement dans l'exemple décrit et se terminant par une extrémité libre 318 et un coude 320 reliant l'extrémité fixe 314 à la portion principale 316. Par soucis de clarté, ces différents éléments des connecteurs électriques 312₁, 3122, 312₃ ne sont indiqués sur la figure 3 que pour deux connecteurs électriques 312₁, 3122, l'un en forme de broche, l'autre en forme de languette.

Dans le cas d'une languette droite, le connecteur électrique 3124 se projette dans le plan principal PP sur une grande longueur afin de permettre sa connexion, par exemple au moins un centimètre. En outre, le connecteur électrique 3124 présente une extrémité fixe 314 fixée à la plaque principale 306, cette extrémité fixe 314 ayant une grande largeur pour permettre le passage de courant, par exemple d'au moins un centimètre.

Les pièces de connexion électrique 304 sont obtenues dans l'exemple décrit par découpage d'une plaque métallique.

Dans l'exemple décrit ici, la plaque métallique est en cuivre. En variante, la plaque métallique pourrait être en aluminium ou encore en or.

Par ailleurs, comme expliqué précédemment, le module de puissance 110 comporte les transistors 112₁, 1122, 114₁, 1142 chacun connecté électriquement entre deux faces supérieures 308, 308₁, 308₂, 308₃ de respectivement deux des plaques principales 306, 306₁, 306₂, 306₃ par exemple pour faire passer et interrompre sur commande un courant de puissance, pouvant par exemple être supérieure à un ampère entre ces deux plaques principales 306, 306₁, 306₂, 306₃. Chaque transistor 112₁, 1122, 114₁, 1142 présente tout d'abord une face inférieure plaquée contre l'une des deux faces supérieures 308₁, 308₂, 308₃ auxquelles ce transistor est connecté électriquement. Chaque transistor 112₁, 1122, 114₁, 1142 présente en outre une face supérieure dont une partie est connecté électriquement à l'autre des deux faces supérieures. Dans l'exemple décrit, la face supérieure du transistor 112₁, 1122, 114₁, 1142 comporte en outre une partie de commande du transistor 112₁, 1122, 114₁, 1142, connectée électriquement à une face supérieure d'une troisième plaque principale 306, par exemple par un fil 328 dans l'exemple décrit.

En d'autres termes, la face inférieure du transistor 112₁ est fixé par brasage sur la zone de montage 309₁₋₁ et connecté électriquement à la face supérieure 308₁ de la plaque principale 306₁ de la première pièce de connexion électrique 304₁.

Comme illustrée à la figure 5 (correspondant à une coupe selon l'axe AA de la figure 4), la réalisation du canal 307₁₋₁ par emboutissage provoque une déformation locale de la face supérieure 308₁ de la plaque principale 306₁ de sorte que de chaque côté du canal 307₁₋₁ une excroissance de métal 305₁, 305₂ s'élève depuis la face supérieure 308₁ de la plaque principale 306₁.

Avantageusement, ces excroissances permettent de s'assurer que le transistor 112₁ ne se déplace pas et reste positionné sur sa zone de montage 309₁₋₁ lors de sa brasure sur celle-ci pendant la phase de refusion. En d'autres termes, la position du transistor 112₁ sur la face supérieure 308₁ de la plaque principales 306₁ est ainsi garantie.

Toutefois, lorsque le transistors 112₁ est brasé sur sa zone de montage 309₁₋₁, l'excroissance de métal 305₂ s'oppose à l'évacuation des bulles de gaz (en langue anglaise, on parle de « voids »), par exemple d'air, pouvant se former dans la brasure sous le transistor 112₁, fragilisant ainsi la fixation du transistor 112₁ sur sa zone de montage 309₁₋₁. De plus, l'apparition de ces bulles de gaz sous le transistor 112₁ peut déplacer ce transistor 112₁ jusqu'à le positionner en appui sur l'excroissance de métal 305₂ bordant le canal 307₁₋₁. Enfin, la formation de bulles de gaz pendant la refusion de la brasure peut générer des explosions de bille de soudure en dehors de la zone à braser de montage 309₁₋₁, causant ainsi des pollutions en dehors de cette zone de montage 309₁₋₁.

Le canal 307₁₋₁ a dans l'exemple décrit ici une forme sensiblement rectangulaire et présente une discontinuité au niveau de chacun des sommets et au niveau du milieu de chacun des côtés de cette forme sensiblement rectangulaire.

Ainsi, au niveau des sommets et au niveau des milieux de chacun des côtés de la forme sensiblement rectangulaire, il n'y a pas de formation d'une excroissance 305₂ ce qui facilite l'évacuation des bulles de gaz pouvant se former dans la brasure sous le transistor 112₁. De cette façon, il est possible d'avoir un taux de bulle de gaz inférieure à 5% après brasage du transistor 112₁. Et d'éviter que le transistor 112₁ se positionne en appui sur l'excroissance de métal 305₂ bordant le canal 307₁₋₁.

Dans une variante de réalisation décrite à la figure 6, le canal 307₁₋₁ a une section comportant un fond 330 et deux parois latérales 331, 332 opposées l'une à l'autre, la paroi latérale 332 située du côté de la zone de montage ayant une pente plus grande que la paroi latérale 331 opposée. En outre dans l'exemple décrit ici de cette variante de réalisation, la paroi latérale 332 située du côté de la zone de montage est sensiblement perpendiculaire à la face supérieure 308₁ de la plaque principale 306₁. En d'autres termes, la pente de la paroi latérale 332 est infinie. Ainsi, lors de la réalisation de ce canal 307₁₋₁, la déformation locale de la face supérieure 308₁ de la plaque principale 306₁ est moindre, à la limite inexistante, du côté du canal 307₁₋₁ situé du côté de la zone de montage 309₁₋₁ que du côté opposé du canal 307₁₋₁. Grâce à cela, l'évacuation des bulles de gaz pouvant se former dans la brasure sous le transistor 112₁ est facilitée.

Comme représenté à la figure 3, un premier élément de liaison électrique connecte électriquement le transistor 112₁ à la face supérieure 308₂ de la plaque principale 306₂ de la deuxième pièce de connexion électrique 3042. Le premier élément de liaison électrique comprend deux rubans 326₁, une extrémité de chaque ruban en métal 326₁ est soudée sur la face supérieure 308₂ de la plaque principale 306₂ de la deuxième pièce de connexion électrique 304₂ par un procédé de soudage. La deuxième extrémité de chaque ruban en métal 326₁ est soudée directement sur le transistor 112₁ par un procédé de soudage. Les procédés de soudage employés sont par exemple des procédés de soudage par ultrason ou par friction.

De même, la face inférieure du transistor 114₁ est fixé par brasage sur la zone de montage 309₂ et connecté électriquement à la face supérieure 308₂ de la plaque principale 306₂ de la deuxième pièce de connexion électrique 3042.

Dans l'exemple décrit ici, le canal 3072 a une section comportant un fond et deux parois latérales opposées l'une à l'autre, la paroi latérale située du côté de la zone de montage ayant une pente infinie. En outre, le canal 3072 a dans l'exemple décrit ici une forme sensiblement rectangulaire et présente une discontinuité au niveau de chacun des sommets et au niveau du milieu de chacun des côtés de cette forme sensiblement rectangulaire.

Un deuxième élément de liaison électrique connecte électriquement le transistor 114₁ à la face supérieure 308₂ de la plaque principale 306₂ de la deuxième pièce de connexion électrique 3042. Le deuxième élément de liaison électrique comprend deux rubans 326₂, une extrémité de chaque ruban en métal 326₂ est soudée sur la face supérieure 308 de la plaque principale 306 d'une pièce de connexion électrique 304 (différente des pièces 304₁, 3042, 304₃) par un procédé de soudage. La deuxième extrémité de chaque ruban en métal 326₂ est soudée directement sur le transistor 114₁ par un procédé de soudage. Les procédés de soudure employés sont par exemple des procédés de soudage par ultrason ou par friction.

De façon similaire, la face inférieure des transistors 112₂ et 114₂ sont fixées par brasage sur la zone de montage 309₁₋₂ et 309₃ et connectés électriquement à la face supérieure 308₁, 308₃ d'une pièce de connexion électrique 304₁, 304₃ et ont leur face supérieure connectée électriquement à une face supérieure d'une autre plaque principale 306₃, 306 au moyen de deux rubans 326.

Dans l'exemple décrit ici, chacun des canaux 307₁₋₂ et 307₃ a une section comportant un fond et deux parois latérales opposées l'une à l'autre, la paroi latérale située du côté de la zone de montage ayant une pente infinie. En outre, les canaux 307₁₋₂ et 307₃ ont dans l'exemple décrit ici une forme sensiblement rectangulaire et présente une discontinuité au niveau de chacun des sommets et au niveau du milieu de chacun des côtés de cette forme sensiblement rectangulaire.

Dans l'exemple décrit, les rubans 326, 326₁, 326₂ sont en aluminium et présente par exemple une section de 2mmx0.3mm. Dans une variante de réalisation, les rubans 326, 326₁, 326₂ sont en or.

Dans l'exemple décrit, le fil 328 est en aluminium et présente un diamètre de 0.2mm Dans une variante de réalisation, le fil 328 est en or.

Dans l'exemple décrit, les connecteurs électriques 312₁ en forme de broche servent à la connexion du module de puissance 110 au module de contrôle 210, afin de faire des mesures de grandeurs électriques et de commander les transistors 112₁, 112₂, 114₁, 114₂.

En outre, toujours dans l'exemple décrit, les connecteurs électriques 3122 sont connectés à la barre omnibus commune négative 108A et le connecteur électrique 312₃ est connecté à la barre omnibus commune positive 106A.

En outre, toujours dans l'exemple décrit, les deux connecteurs électriques 3124 en forme de languette droite forment respectivement les deux barres omnibus de phase 122₁, 1222 du module de puissance 110.

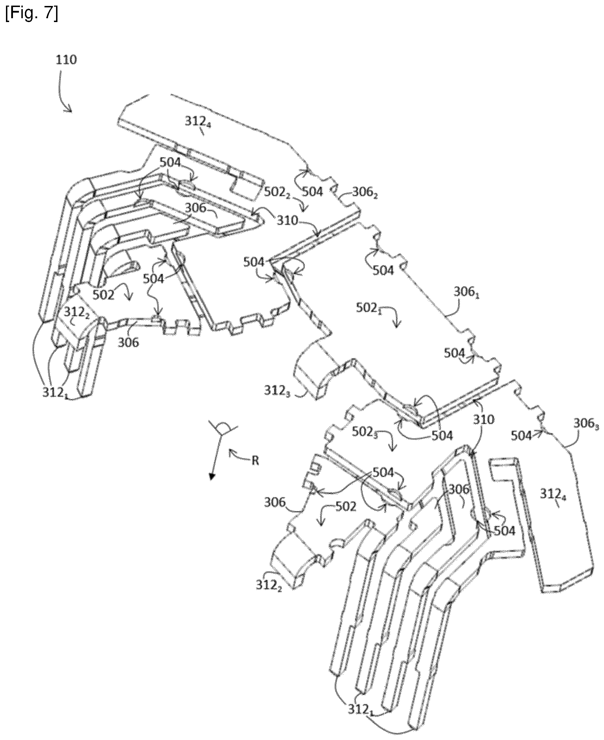

En référence à la figure 7, au moins une des plaques principales 306, 306₁, 3062, 306₃ présente, sur une face inférieure 502, 502₁, 5022, 502₃ au moins une cavité 504 de retenue du surmoulage 402. Chaque cavité de retenue 504 est ouverte sur la tranche de la plaque principale 306, 306₁, 306₂, 306₃ présentant cette cavité. En d'autres termes, la cavité de retenue 504 se situe à la périphérie de la face inférieure 502, 502₁, 5022, 502₃ de la plaque principale 306, 306₁, 306₂, 306₃. En outre, chaque cavité de retenue 504 définit une marche horizontale décalée verticalement au-dessus de la face inférieure 502, 502₁, 5022, 502₃ de la plaque principale 306, 306₁, 306₂, 306₃. Chaque cavité de retenue 504 est réalisée par exemple par emboutissage.

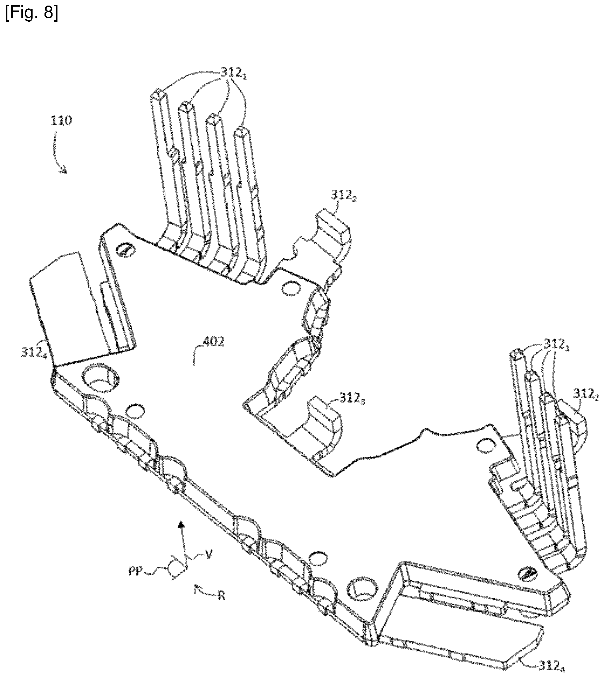

En référence à la figure 8, le surmoulage du module de puissance 110 est représenté et porte la référence 402. Le surmoulage 402 est un isolant électrique et recouvre entièrement chaque transistor 112₁, 1122, 114₁, 1142, chaque rubans 326, 326₁, 326₂ et chaque fil 328 et au moins une partie des faces supérieures 308, 308₁, 308₂, 308₃ des plaques principales 306, 306₁, 306₂, 306₃.

Le surmoulage 402 est par exemple en résine, par exemple encore en époxy. De préférence, le surmoulage 402 est intégral en une seule pièce.

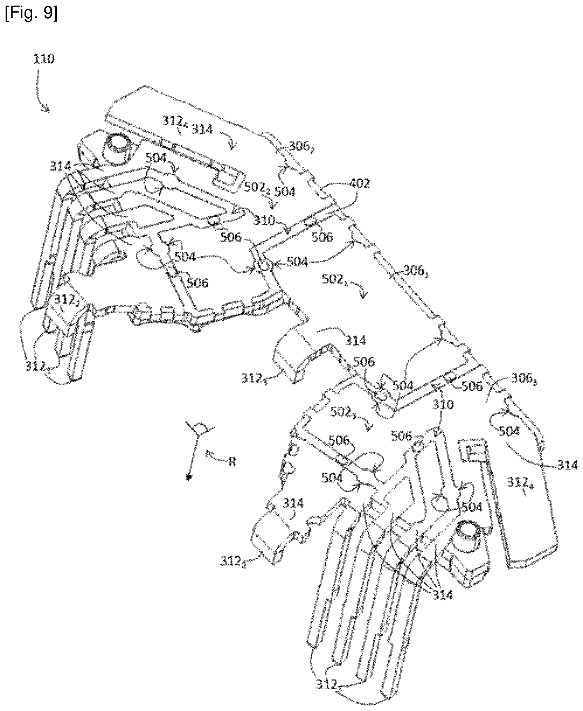

Comme cela est visible sur la figure 9, le surmoulage 402 laisse apparent la face inférieure 502₁ de la plaque principale 306₁ de la première pièce de connexion électrique 304₁. Cette partie laissée apparente est conçue pour être plaquée contre le dissipateur thermique 206. Ainsi, le dissipateur thermique 206 est en contact thermique avec la face inférieure 502₁ laissée apparente par le surmoulage 402. Ce contact thermique peut être un contact direct ou bien via un élément de liaison électrique isolant et thermiquement conducteur.

De même, le surmoulage 402 laisse apparent les faces inférieures 502, 5022, 502₃ des plaque principale 306, 306₂, 306₃ de chacune des autres pièces de connexion électrique 304, 3042, 304₃. Ces parties laissées apparentes sont conçues pour être plaquée contre le dissipateur thermique 206. Ainsi, le dissipateur thermique 206 est en contact thermique avec les faces inférieures 502, 5022, 502₃ laissées apparentes par le surmoulage 402. Ce contact thermique peut être un contact direct ou bien via un élément de liaison électrique isolant et thermiquement conducteur.

En outre, chaque cavité de retenue 504 est remplie par le surmoulage 402, et le surmoulage 402 présente, dans cette cavité de retenue 504, une face inférieure affleurant la face inférieure 502 de la plaque principale 306.

Par ailleurs, il sera apprécié que l'extrémité fixe 314 de chaque connecteur électrique 312₁, 3122, 312₃, 3124 présente une face inférieure entièrement découverte de surmoulage 402. En outre, le surmoulage 402 remplit chaque interstice 310 et présente, dans chaque interstice 310, une face inférieure affleurant les faces inférieures 502, 502₁, 5022, 502₃ des plaques principales 306, 306₁, 306₂, 306₃.

Le surmoulage 402 présente au moins un plot en résine 506 se projetant vers le bas et conçu pour venir au contact direct du dissipateur thermique 206 afin de définir un écartement prédéfini entre les faces inférieures 502, 502₁, 5022, 502₃ des plaques principales 306, 306₁, 306₂, 306₃ et le dissipateur thermique 206, et ainsi l'épaisseur de l'élément conducteur thermique remplissant cet écartement. Dans l'exemple décrit, chaque plot en résine 506 se projette depuis la face inférieure du surmoulage présent dans l'un des interstices 310 entre les plaques principales 306, 306₁, 306₂, 306₃.

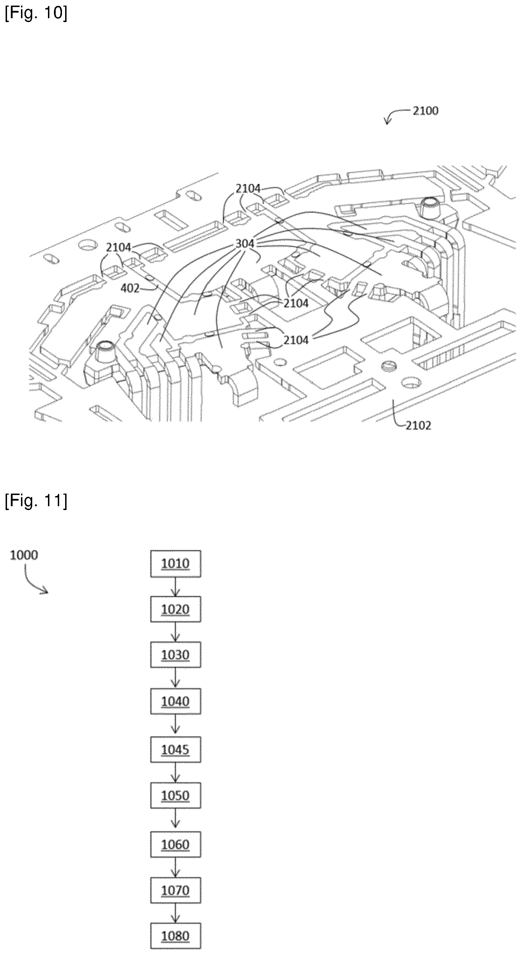

La figure 10 illustre une plaque conductrice 2100, de préférence en métal, s'étendant selon le plan principal et dans laquelle sont découpées tout d'abord plusieurs pièces planes comportant une pièce de cadre 2102 et les pièces de connexion électrique 304 du module de puissance. Comme expliqué précédemment, chaque pièce de connexion électrique 304 présente une plaque principale et, éventuellement, au moins un connecteur électrique se projetant depuis sa plaque principale. Sur la figure 10, les connecteurs électriques 312₁, 3122, 312₃ ont été pliés. Dans la plaque conductrice 2100 sont en outre formées des pattes d'attache 2104 de chaque plaque principale avec au moins une de la ou des autres pièces (autre pièce de connexion 304 ou bien pièce de cadre 2102). Dans la plaque conductrice 2100 sont en outre également formées des pattes secondaires d'attache de chaque pièce de connexion électrique devant être pliée avec au moins une autre pièce de connexion électrique ou avec la pièce de cadre 2102. Sur la figure 10, ces pattes secondaires d'attache ne sont pas visibles. Les transistors 112₁, 1122, 114₁, 1142 sont fixés et connectés électriquement et le surmoulage 402 a été réalisé, en particulier de manière à recouvrir totalement les transistors 112₁, 1122, 114₁, 1142 et au moins une partie des faces supérieures des plaques principales, ainsi qu'au moins partiellement au moins certaines des pattes d'attache 2104. Dans l'exemple décrit, le surmoulage 402 s'étend jusqu'au plan des faces inférieures des plaques principales des pièces de connexion 304.

En référence à la figure 11, un procédé 1000 de fabrication du module de puissance 110 va à présent être décrit.

Au cours d'une étape 1010, une plaque conductrice 2100 s'étendant selon un plan principal PP est obtenue.

Au cours d'une étape 1020, la plaque conductrice obtenue à l'étape précédente est découpée pour définir la pièce de cadre 2102 et les pièces de connexion 304.

Au cours d'une étape 1030, les canaux 307₁₋₁, 307₁₋₂, 3072 et 307₃ sont réalisés par emboutissage de sorte que ces canaux 307₁₋₁, 307₁₋₂, 3072 et 307₃ possèdent une section de forme trapézoïdale. Cette opération d'emboutissage est par exemple réalisée en utilisant des poinçons dont les sections correspondent aux sections voulues des canaux 307₁₋₁, 307₁₋₂, 307₂ et 307₃.

Au cours d'une étape 1040, les transistors 112₁, 1122, 114₁, 1142 sont obtenus.

Au cours d'une étape 1045, les transistors 112₁, 1122, 114₁, 1142 sont fixés et électriquement connectés aux plaques principales 306 des pièces de connexion 304.

Au cours d'une étape 1050, le surmoulage 402 est réalisé avec un matériau isolant électrique, par exemple de la résine, de manière à recouvrir totalement les transistors 112₁, 1122, 114₁, 1142 et au moins une partie des faces supérieures 308 des plaques principales 306. De préférence, cette étape est réalisée par coulage ou injection en une seule fois dans une seule cavité de moule.

Au cours d'une étape 1060, les pattes secondaires d'attache des connecteurs électrique 312₁, 3122, 312₃ sont coupées.

Au cours d'une étape 1070, les connecteurs électrique 312₁, 3122, 312₃ sont pliés pour placer leurs portions principales à la verticale. Le résultat de cette étape est illustré sur la figure 10.

Au cours d'une étape 1080, les pattes d'attache 2104 sont coupées pour séparer chaque pièce de connexion électrique 304 de la ou des autres pièces.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué.

Par exemple, les canaux 307₁₋₁, 307₁₋₂, 3072 et 307₃ peuvent être réalisés par estampage. En variante, les canaux 307₁₋₁, 307₁₋₂, 3072 et 307₃ peuvent être réalisés par gravure laser.

De même, dans une variante de réalisation, le surmoulage isolant électrique 402 pourrait ne pas recouvrir totalement les transistors 112₁, 1122, 114₁, 1142.

Dans la présentation détaillée de l'invention qui est faite précédemment, les termes utilisés ne doivent pas être interprétés comme limitant l'invention aux modes de réalisation exposés dans la présente description, mais doivent être interprétés pour y inclure tous les équivalents dont la prévision est à la portée de l'homme de l'art en appliquant ses connaissances générales à la mise en œuvre de l'enseignement qui vient de lui être divulgué.

## Revendications

1. Module électronique (110) comprenant :
- un premier composant électronique (112₁) ;
- une première (304₁) pièce de connexion électrique, de préférence en métal, présentant une première plaque principale (306₁) et comprenant sur une face supérieure (308₁) de ladite première plaque principale (306₁) une zone de montage (309₁₋₁) destinée à recevoir ledit premier composant électronique (112₁), ledit premier composant électronique (112₁) étant fixé par brasage sur la zone de montage (309₁₋₁) de la première pièce de connexion électrique (304₁) ;
- un surmoulage isolant électrique (402), par exemple en résine, recouvrant au moins une partie de la face supérieure (308₁) de la première plaque principale (306₁) de la première (304₁) pièces de connexion électrique;
ledit module électronique (110) étant **caractérisé en ce que** ladite face supérieure (308₁) de la première plaque principale (306₁) de ladite première pièce de connexion électrique (304₁) comprend en outre un canal (307₁₋₁) entourant ladite zone de montage (309₁₋₁).

2. Module électronique (110) selon la revendication précédente dans lequel ledit canal (307₁₋₁) est discontinu.

3. Module électronique (110) selon l'une des revendications précédentes dans lequel ledit canal (307₁₋₁) a une forme sensiblement rectangulaire

4. Module électronique (110) selon la revendication précédente dans lequel ledit canal (307₁₋₁) présente une discontinuité au niveau d'au moins un sommet de ladite forme sensiblement rectangulaire.

5. Module électronique (110) selon l'une des revendications 3 à 4 dans lequel ledit canal (307₁₋₁) présente une discontinuité au niveau d'un milieu d'au moins un des côtés de ladite forme sensiblement rectangulaire.

6. Module électronique (110) selon l'une des revendications précédentes dans lequel ledit canal (307₁₋₁) est réalisé par emboutissage et/ou par estampage et/ou par gravure laser.

7. Module électronique (110) selon l'une des revendications précédentes dans lequel ledit canal (307₁₋₁) a une section ayant une forme trapézoïdale.

8. Module électronique (110) selon l'une des revendications précédentes dans lequel ledit canal (307₁₋₁) a une section comportant un fond (330) et deux parois latérales (331, 332) opposées l'une à l'autre et dans lequel la paroi latérale (332) située du côté de la zone de montage (309₁₋₁) a une pente plus grande que la paroi latérale (331) opposée.

9. Module électrique (110) selon l'une des revendications précédentes dans lequel le surmoulage (402) laisse apparent au moins une partie d'une face inférieure (502₁) de la première plaque principale (306₁) de la première pièce de connexion électrique (304₁), cette partie laissée apparente étant conçue pour être plaquée contre un dissipateur thermique (206).

10. Système électronique (100) comprenant un dissipateur thermique (206) et un module électrique (110) selon la revendication précédente, et dans lequel le dissipateur thermique (206) est en contact thermique avec l'au moins une partie de la face inférieure (502₁) laissée apparente par le surmoulage (402).

11. Convertisseur de tension (104) comprenant un module électrique (110) selon l'une quelconque des revendications 1 à 9 ou bien un système électronique (100) selon la revendication 10.

12. Engin de mobilité comprenant un module électronique selon l'une des revendications 1 à 9 ou bien un système électronique (100) selon la revendication 10 ou un convertisseur de tension selon la revendication 11.

13. Procédé de fabrication d'un module électronique (110) selon la revendication 1 comprenant :
- L'obtention (1040) d'un premier composant électronique (112₁) ;
- L'obtention (1010, 1020) d'une première (304₁) pièce de connexion électrique, de préférence en métal, présentant une première plaque principale (306₁) et comprenant sur une face supérieure (308₁) de ladite première plaque principale (306₁) une zone de montage (309₁₋₁) destinée à recevoir ledit premier composant électronique (112₁),
- La réalisation (1030) d'un canal (307₁₋₁) entourant ladite zone de montage (309₁₋₁) sur la face supérieure (308₁) de la première plaque principale (3061) de ladite première pièce de connexion électrique (304₁).
- La fixation (1045) par brasage du premier composant électronique (112₁) sur la zone de montage (309₁₋₁) de la première pièce de connexion électrique (304₁) ;
- La réalisation (1050) d'un surmoulage isolant électrique (402), par exemple en résine, recouvrant au moins une partie de la face supérieure (308₁) de la première plaque principale (306₁) de la première (304₁) pièces de connexion électrique.
